# EUROPÄISCHE PATENTSCHRIFT

(11) **EP 0 945 208 B1**
(45) Veröffentlichungstag und Bekanntmachung des Hinweises auf die Patenterteilung: **03.03.2004**
(21) Anmeldenummer: 98123402.4
(22) Anmeldetag: 09.12.1998
(51) Int. Cl.: B23K 20/00, H01L 21/00, H01L 21/603, H01L 21/607

(54) **Verfahren und Vorrichtung zum "ball-bonden"**
Apparatus and method for ball bonding
Procédé et dispositif de fixation par balle

(30) Priorität: 23.03.1998 DE 19812706
(43) Veröffentlichungstag der Anmeldung: 29.09.1999
(73) Patentinhaber: F & K Delvotec Bondtechnik GmbH, 85521 Ottobrunn (DE)
(72) Erfinder: Farassat, Farhad, Dr., 82024 Taufkirchen (DE)
(74) Vertreter: Popp, Eugen, Dr.

(56) Entgegenhaltungen:
- EP-A- 0 276 564
- EP-A- 0 402 756
- WO-A-98/53485
- US-A- 4 205 773
- US-A- 4 444 349
- US-A- 5 156 320
- US-A- 5 207 786
- US-A- 5 559 054

## Beschreibung

Die Erfindung betrifft ein Verfahren und eine Vorrichtung zum "ball-bonden" gemäß den Oberbegriff des Anspruchs 3 (siehe, z.B. EP-A-0 276 564).

EP-A-0 276 564 offenbart auch ein Verfahren zum "ball-bonden", insbesondere Golddraht-Bondverfahren, welches folgende Arbeitsschritte umfaßt:
a) Positionieren und Absenken einer Bond-Kapillare (10) mit einer abgeflammten Bonddraht-Kugel (ball 12) am unteren freien Ende eines Bonddrahtes (11) aus einer hochgefahrenen Ausgangsposition auf eine erste Bondstelle (17);
b) Aufschweißen des balls (12) unter Wärmezugabe, definiertem Anpreßdruck und/oder Einwirkung von Ultraschall;
c) Hochfahren der Bond-Kapillare (10);
d) Bildung einer Bonddraht-Schleife (25);
e) Aufschweißen des Bonddrahtes (11) an einer zweiten Bondstelle (16) unter Wärmezugabe, definiertem Anpreßdruck und/oder Einwirkung von Ultraschall;
f) Festklemmen des Bonddrahtes (11) mittels einer diesem zugeordnetem Drahtklemme (13);
g) Hochfahren der Bond-Kapillare (10) samt Drahtklemme (13), wodurch der Bonddraht (11) an der zweiten Bondstelle (16) abgerissen wird; und öffnung der Drahtklemme
h) Relativbewegung der Bond-Kapillare (10) gegenüber dem Bonddraht (11) nach oben durch eine Betätigungs einrichtung unter Freilegung eines freien Bonddrahtendes (tails 31);
i) Abflammen des tails (31) unter Ausbildung eines neuen balls (12);
j) Zurückbewegung der Bond-Kapillare (10) relativ zum Bonddraht (11) in die Relativstellung gemäß Arbeitsschritt (g) nach vorheriger Freigabe des Bonddrahtes (11);
k) Absenken der Bond-Kapillare (10) unter Mitnahme des balls (12) samt Bonddraht (11) zu einer neuen ersten Bondstelle (17) und Aufschweißen des balls (12) an dieser entsprechend Arbeitsschritt (b).

Aus der auf die Anmelderin zurückgehenden EP 0 299 987 B1 ist ein Verfahren zum "ball-bonden" mit Golddraht bekannt, welches folgende Arbeitsschritte umfaßt:
a) Positionieren und Absenken einer Bond-Kapillare mit einer abgeflammten Bonddraht-Kugel (ball) am unteren, freien Ende eines Bonddrahtes aus einer hochgefahrenen Ausgangsposition auf eine erste Bondstelle;
b) Aufschweißen des balls unter Wärmezugabe, definiertem Anpreßdruck und/oder Ultraschallunterstützung;
c) Hochfahren der Bond-Kapillare;
d) Bildung einer Bonddraht-Schleife;
e) Aufschweißen des Bonddrahtes an einer zweiten Bondstelle unter Wärmezugabe, definiertem Anpreßdruck und/oder Ultraschallunterstützung;
f) Hochfahren der Bond-Kapillare in eine vorgegebene "taillength"-Position, Abreißen des Bonddrahtes durch Ausübung eines Zuges auf diesen mittels einer am Bonddraht angreifenden Drahtklemme und anschließend Hochfahren der Bond-Kapillare in die Ausgangsposition;
g) Abflammen des freien Bonddrahtendes unter Ausbildung eines neuen balls;
   wobei
h) nach dem Aufschweißen des Bonddrahtes an der zweiten Bondstelle die Drahtklemme aktiviert und in Drahtklemmstellung gebracht wird;
i) dann zwischen der Drahtklemme und der zweiten Bondstelle eine elektrische Spannung angelegt wird;
j) hieraufhin die Drahtklemme unter Ausübung eines Zuges auf den Bonddraht hochgefahren und beim Abriß des Bonddrahtes durch Unterbrechung der elektrischen Verbindung zwischen Drahtklemme und zweiter Bondstelle angehalten wird;
k) anschließend die Wegstrecke der Drahtklemme bis zum Abriß des Bonddrahtes und damit bis zur Unterbrechung der elektrischen Verbindung zwischen Drahtklemme und zweiter Bondstelle gemessen wird; und
l) eine als Einrichtung zum Abflammen des freien Bonddrahtes vorgesehene Abflammlanze unter Berücksichtigung der gemessenen Drahtklemme-Wegstrecke dem freien Bonddrahtende bzw. der Drahtspitze so zugeordnet wird, daß die Abflammlanze einen vorbestimmten Abstand zum freien Bonddrahtende bzw. zur Drahtspitze aufweist.

Dieses Verfahren hat sich in der Praxis bewährt. Gleiches gilt für die zugeordnete Vorrichtung, die im wesentlichen dadurch gekennzeichnet ist, daß der den Abriß des Bonddrahtes bewirkenden Drahtklemme ein Schrittantrieb zugeordnet ist, der mit einem Zählwerk gekoppelt ist, welches die von der Drahtklemme zurückgelegte Wegstrecke bestimmt und für die erneute Bestimmung einer weiteren Wegstrecke auf Null einstellbar ist.

Ergänzend sei noch auf das in der US-A 4 586 642 beschriebene "ball-bond-Verfahren" verwiesen, welches mit dem Verfahren gemäß der EP 0 299 987 B1 die Arbeitsschritte a) bis g) gemeinsam hat. Die dazugehörige Vorrichtung ist durch einen ringförmigen, den Bonddraht umgebenden und zwischen der Bond-Kapillare einerseits und der Drahtklemme andererseits angeordneten Magnetkern sowie eine mit dem Magnetkern zusammenwirkende Spule gekennzeichnet, welche an einen Oszillator angeschlossen ist. Der Oszillator, der selbst in einem Computersystem integriert ist, erzeugt bestimmte Frequenzspannungen in vorgegebenen Zeitintervallen. Anhand einer Eichkurve, bei welcher die Frequenz über der Zeit aufgetragen ist, soll ein Vergleich mit der jeweiligen tatsächlichen Kurve des momentanen Bondvorganges, bei welcher ebenfalls die Frequenz über die Zeit aufgetragen ist, stattfinden können. Anhand eines solchen Vergleichs wiederum sollen bei einem bestimmten Bondvorgang auftretende Unregelmäßigkeiten durch Abweichungen in der Frequenz und/oder Zeit festgestellt und sodann für weitere nachfolgende Bondvorgänge durch entsprechende Korrektur behoben werden können.

All den bekannten Verfahren ist gemeinsam, daß der Bonddraht beim Hochfahren der Bond-Kapillare trotz offener Drahtklemme unkontrolliert abreißt mit der Folge, daß keine vorbestimmte "tail-length" herstellbar ist. Die Folge ist, daß auch die Herstellung eines "balls" mit vorgegebener Größe nicht sicher herstellbar ist. Im Extremfall kann es sogar geschehen, daß durch unerwünschtes Abreißen des Bonddrahtes beim Hochfahren der Bond-Kapillare eine "tail-length" von nahezu Null entsteht. In diesem Fall muß die Bond-Vorrichtung abgestellt und Draht manuell nachgefahren werden. Es ist augenscheinlich, daß unter den heute geltenden Produktionsbedingungen eine solche Produktionsunsicherheit nicht mehr akzeptiert wird. Vor allem wird auch nicht mehr akzeptiert, daß unterschiedliche "ball-Größen" entstehen, aufgrund des erwähnten unkontrollierten Drahtabrisses. Dies gilt ganz besonders für das Golddraht-Bonden mit extrem dünnen Golddrähten. Durch den erwähnten Mangel geht auch Golddraht verlustig; auch dies gilt es zu vermeiden.

Der vorliegenden Erfindung liegt daher die Aufgabe zugrunde, ein Verfahren und eine Vorrichtung zum "ball-bonden", insbesondere Golddraht-bonden zu schaffen, mit dem bzw. der eine präzise "tail-length" und damit auch "ball-Größe" herstellbar sind und mit dem bzw. der Produktionsunterbrechungen mit großer Wahrscheinlichkeit vermieden werden können.

Dabei ist zu bedenken, daß Golddraht zum Golddraht-bonden mit stark unterschiedlicher Qualität geliefert wird, so daß die herkömmlichen Vorrichtungen zwar für hochqualitative Golddrähte ausreichend funktionssicher sind, nicht jedoch für geringer-qualitative Golddrähte. Da der Benutzer von Bond-Vorrichtungen jedoch sehr häufig nicht weiß, um welche Qualität es sich bei dem verwendeten Golddraht handelt, gilt es, hier verfahrens und vorrichtungstechnisch Abhilfe zu schaffen, dergestalt, daß auch geringer-qualitative Golddrähte funktionssicher verarbeitet werden können.

Die Erfindung ist durch ein Verfahren mit den Merkmalen des Anspruchs 1, und eine Vorrichtung mit den Merkmalen des Anspruchs 3 definiert. Sowohl das Verfahren als auch die Vorrichtung gemäß Erfindung zeichnen sich gegenüber dem Stand der Technik vor allem dadurch aus, daß die Bond-Kapillare nach Ausbildung eines Bonds an der zweiten Bondstelle hochgefahren wird, nachdem vorher der Bonddraht durch die zugeordnete Drahtklemme festgeklemmt worden ist. Damit reißt der Bonddraht an der zweiten Bondstelle in kontrollierter Weise ab. In der hochgefahrenen Position der Bond-Kapillare oder alternativ vor dem Hochfahren der Bond-Kapillare wird diese relativ zum Bonddraht nach oben bewegt, so daß ein unterer Drahtabschnitt bzw. "tail" mit vorbestimmter "tail-length" freigelegt wird. Die Größe der "tail-length" wird durch eine der Bond-Kapillare zugeordnete Betätigungseinrichtung bestimmt, die vorzugsweise mit einem Rechner in Verbindung steht, der programmierbar ist. Damit kann die "tail-length" exakt eingestellt werden, und zwar stets in bezug auf einen kontrollierten Draht-Abriß bzw. ein vorbestimmtes Drahtende. Dies wird erfindungsgemäß dadurch erreicht, daß beim Abreißen des Golddrahtes die "tail-length" nahezu Null beträgt. Erst durch die erfindungsgemäße Relativbewegung der Bond-Kapillare gegenüber dem Bonddraht entsteht ein "tail" mit vorbestimmter "tail-length", der zu einem entsprechend präzisen "ball" umgeformt werden kann. Vor allem ist dann auch sichergestellt, daß beim Abflammen des freien Drahtendes bzw. "tails" unter Herstellung des gewünschten "balls" kein Draht verlorengeht. Der Drahtverlust kann durch das erfindungsgemäße Verfahren und die erfindungsgemäße Vorrichtung auf Null reduziert werden.

Anhand der beigefügten Zeichnungen werden das erfindungsgemäße Verfahren und die erfindungsgemäße Vorrichtung im Prinzip näher erläutert. Es zeigen:

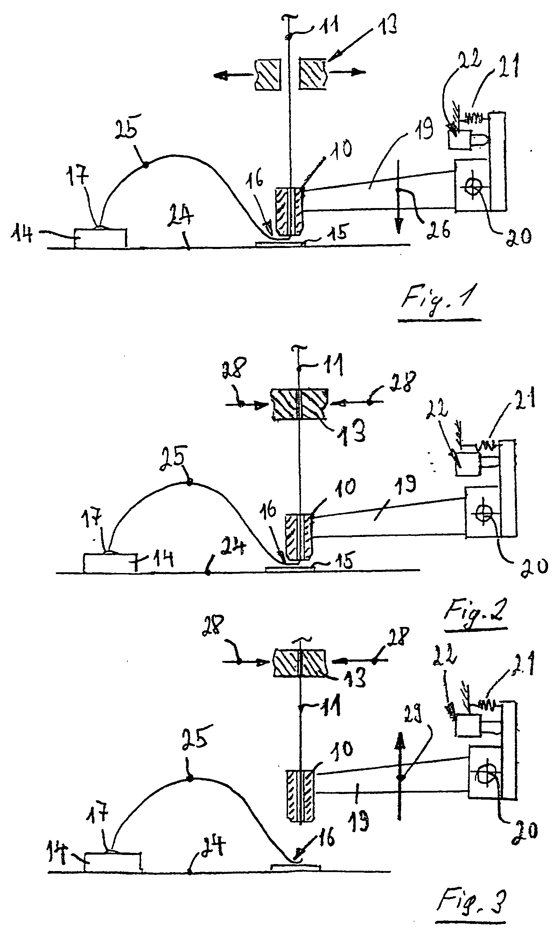

Figur 1 bis 7 den prinzipiellen Verfahrensablauf des erfindungsgemäßen "ball-bond-Verfahrens" mit dazugehöriger Vorrichtung in schematischer Ansicht.

In den anliegenden Figuren sind mit der Bezugsziffer 10 eine Bond-Kapillare, 11 ein Gold-Bonddraht mit einem Mini-ball 12 (Figur 7) am unteren freien Drahtende, 13 eine am Bonddraht 11 angreifende Drahtklemme, 14 ein Bauelement mit einer ersten Bondstelle 17, 15 ein lead-frame oder dgl. Bauelement mit einer zweiten Bondstelle 16 und mit der Bezugsziffer 18 eine Abflammlanze (Figuren 5 und 6) gekennzeichnet. Die Bond-Kapillare 10 ist am freien Ende eines Ultraschall-transducers 19 angeordnet, der um eine waagrechte Achse 20 verschwenkbar am nicht näher dargestellten Bondkopf gelagert ist. Die Schwenk-Lagerung des transducers 19 samt Bond-Kapillare 10 erfolgt unter der Einwikung eines "Bondgewichts", hier in Form einer Zugfeder 21, der ein Verstellorgan in Form eines Piezo-Antriebs 22 entgegenwirkt.

Grundsätzlich stellt sich das Bonden mit der beschriebenen Vorrichtung wie folgt dar:

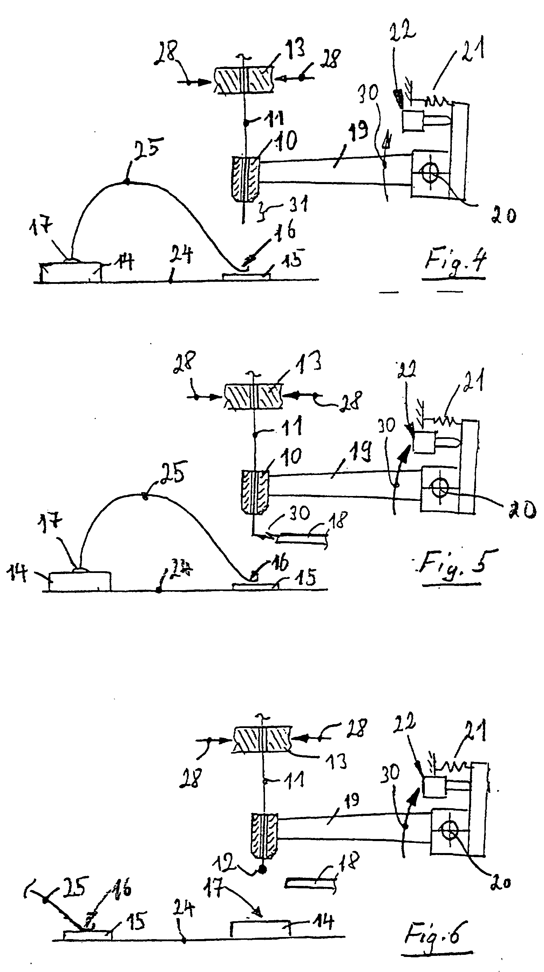

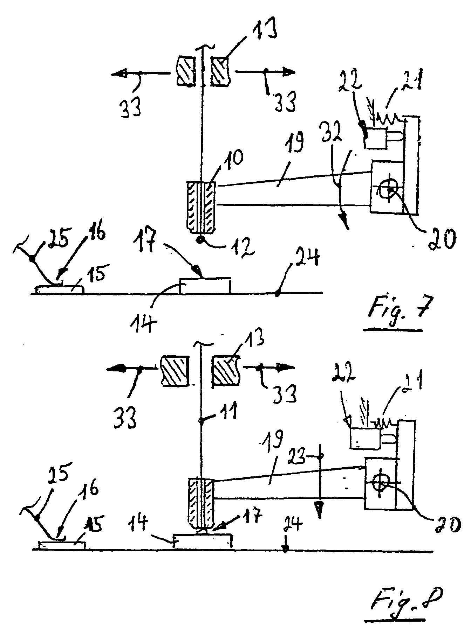

In einem ersten Schritt wird die Bond-Kapillare 10 auf einer hochgefahrenen Stellung entsprechend Figur 7 mit einer abgeflammten Bonddrahtkugel (ball 12) am unteren freien Ende des Bonddrahtes 11 auf eine erste Bondstelle 17 abgesenkt in Richtung des Pfeils 23 in Figur 8. Es erfolgt dann unter Wärmezugabe, definiertem Anpreßdruck (bestimmt durch das Bondgewicht 21 einerseits und Verstellorgan 22 andererseits) sowie unter Einwirkung von Ultraschall über den transducer 19 ein Aufschweißen des balls 12 an der ersten Bondstelle 17 (Figur 8). Anschließend wird die Bond-Kapillare 10 hochgefahren und relativ zu einem die Bauelemente 14 und 15 tragenden Substrat 24 bewegt unter Ausbildung einer Bonddraht-Schleife 25 (siehe Figuren 1 bis 5). Danach erfolgt das Aufschweißen des Bonddrahts 11 an einer zweiten Bondstelle 16 entsprechend Figur 1 ebenfalls unter Wärmezugabe, definiertem Anpreßdruck und Einwirkung von Ultraschall. Dieses Aufschweißen unter entsprechender Absenkung der Bond-Kapillare 10 ist in Figur 1 mit dem Pfeil 26 angedeutet.

Danach wird der Bonddraht 11 mittels der zugeordneten Drahtklemme 13 festgeklemmt (siehe Pfeile 28 in Figur 2, die die Bewegung der Klemmbacken der Drahtklemme 13 in Drahtklemmstellung anzeigen).

Entsprechend Figur 3 wird nach der Ausbildung der zweiten Bondstelle 16 die Bond-Kapillare 10 samt transducer 19 und Drahtklemme 13 hochgefahren, wodurch der Bonddraht 11 an der zweiten Bondstelle 16 abgerissen wird (siehe Figur 3). Das Hochfahren der Bond-Kapillare 10 ist in Figur 3 mit dem Pfeil 29 dargestellt. Das abgerissene Drahtende befindet sich an der Unterseite der Bond-Kapillare 10. Es handelt sich dabei um eine definierte Abreißstelle.

Anschließend erfolgt entsprechend Figur 4 eine Relativbewegung der Bond-Kapillare 10 gegenüber dem nach wie vor festgeklemmten (Pfeile 28) Bonddraht 11 nach oben, und zwar durch Verschwenken der Bond-Kapillare 10 samt transducer 19 um die Schwenkachse 20 in Richtung des Pfeils 30, wodurch ein vorbestimmter unterer Abschnitt des Bonddrahtes 11 bzw. ein sogenannter "tail" 31 mit vorbestimmter "tail-length" freigelegt wird. Die Schwenkbewegung in Richtung des Pfeiles 30 erfolgt durch Aktivierung des Piezo-Antriebs 22 gegen die Wirkung des "Bondgewichtes" bzw. der Zugfeder 21. Zur Ausbildung eines Mini-balls 12 am freien Ende des Bonddrahtes bzw. "tails" 31 wird diesem eine Abflammlanze 18 zugestellt und diese aktiviert (Abflammfunke 30). Dadurch verformt sich der "tail" 31 zu einem ball 12 vorbestimmter Größe. Die Größe des balls 12 hängt von der Länge des "tails" 31 bzw. der sogenannten "tail-length" ab. Nach Ausbildung des Mini-balls 12 entsprechend Figur 6 und Öffnen der Drahtklemme 13 in Richtung der Pfeile 33 in Figur 7 wird die Bond-Kapillare 10 relativ zum Bonddraht 11 zurückbewegt bzw. zurückgeschwenkt entsprechend Pfeil 32 in Figur 7, und zwar durch Deaktivierung des Piezo-Antriebs 22 unter der Wirkung des Bondgewichts bzw. der Zugfeder 21. Dadurch kommt das untere Ende der Bond-Kapillare 10 in Anlage an den Mini-ball 12 unter Mitnahme desselben. Zur Sicherstellung der Anlage des Mini-balls 12 am unteren Ende der Bond-Kapillare 10 ist es vorteilhaft, nach Freigabe des Bonddrahtes 11 durch die Drahtklemme 13 den Bonddraht 11 durch Einwirkung von Unterdruck, Reibrollen oder dgl. Mittel in Rückzugsstellung zu halten, ohne ihn jedoch festzuklemmen. Danach läßt sich die Bond-Kapillare unter entsprechender Mitnahme des balls 12 samt Bonddraht 11 zu einer neuen ersten Bondstelle 17 und Aufschweißen des balls 12 an dieser absenken, so wie dies in Figur 8 dargestellt ist.

Die in den Figuren 1 bis 8 nur schematisch dargestellte Vorrichtung zur Durchführung des beschriebenen Verfahrens zeichnet sich durch eine Bond-Kapillare 10 aus, durch die hindurch der Bonddraht 11 geführt und mittels der der Bonddraht 11 auf die ersten und zweiten Bondstellen 16 und 17 aufschweißbar ist. Des weiteren umfaßt die Vorrichtung eine am Bonddraht 11 angreifende Drahtklemme 13, die oberhalb der Bond-Kapillare 10 wirksam ist. Mittels dieser Drahtklemme 13 ist der Bonddraht 11 bei Bedarf, d.h. in der beschriebenen Weise festklemmbar. Die Bond-Kapillare 10 ist in hochgefahrener Stellung bei festgeklemmtem Bonddraht 11 durch eine Betätigungseinrichtung 21, 22 relativ zum Bonddraht 11 bewegbar, insbesondere nach oben verschwenkbar in Richtung des Pfeils 30 unter Herstellung eines nach unten vorstehenden, eine vorbestimmte "tail-length" definierenden Drahtabschnitts bzw. "tails" 31. Das freie untere Ende des "tails" 31 ist der bereits erwähnten

Abflammeinrichtung bzw. Abflammlanze 18 zustellbar, so daß nach deren Aktivierung ein Mini-ball 12 aus dem sogenannten "tail" 31 herstellbar ist. Die Betätigungseinrichtung für die Bond-Kapillare 10 umfaßt einen Schwenkarm, hier einen schwenkbar gelagerten Ultraschall-transducer 19 an dessen einem Ende die Bond-Kapillare 10 angeordnet ist und an dessen anderem Ende ein "Bondgewicht", hier in Form einer Zugfeder 21 angreift, entgegen dessen bzw. deren Wirkung ein Verstellorgan in Form eines Piezo-Antriebs 22 wirksam ist. Der Piezo-Antrieb 22 ist vorzugsweise programmierbar und zu diesem Zweck mit einem der Bondvorrichtung zugeordneten Rechner verbunden. Damit läßt sich die für die Ausbildung eines vorbestimmten balls 12 erforderliche "tail-length" präzise einstellen. Statt eines Piezo-Antriebs kann als Verstellorgan auch ein Linearmotor, hydro-pneumatischer Antrieb oder dgl. dienen. Durch das Verstellorgan 22 läßt sich auch das "Bondgewicht" in vorbestimmter Weise beeinflussen.

Die Vorteilhaftigkeit des beschriebenen Verfahrens und der dazugehörigen Vorrichtung ist bereits eingangs dargestellt.

### Bezugszeichenliste

- 10: Bond-Kapillare
- 11: Gold-Bonddraht,
- 12: ball,
- 13: Drahtklemme,
- 14: Bauelement,
- 15: lead-frame,
- 16: zweite Bondstelle,
- 17: erste Bondstelle,
- 18: Abflammlanze,
- 19: Ultraschall-transducer,
- 20: Schwenkachse,
- 21: Zugfeder,
- 22: Piezo-Antrieb, (Verstellorgan)
- 23: Pfeil,
- 24: Substrat,
- 25: Bonddraht-Schleife,
- 26: Pfeil,
- 28: Pfeile,
- 29: Pfeil,
- 30: Abflammfunke,
- 31: tail,
- 32: Pfeil,
- 33: Pfeile

## Patentansprüche

1. Verfahren zum "ball-bonden", insbesondere Golddraht-Bondverfahren, welches folgende Arbeitsschritte umfaßt:
a) Positionieren und Absenken einer Bond-Kapillare (10) mit einer abgeflammten Bonddraht-Kugel (ball 12) am unteren freien Ende eines Bonddrahtes (11) aus einer hochgefahrenen Ausgangsposition auf eine erste Bondstelle (17);
b) Aufschweißen des balls (12) unter Wärmezugabe, definiertem Anpreßdruck und/oder Einwirkung von Ultraschall;
c) Hochfahren der Bond-Kapillare (10);
d) Bildung einer Bonddraht-Schleife (25);
e) Aufschweißen des Bonddrahtes (11) an einer zweiten Bondstelle (16) unter Wärmezugabe, definiertem Anpreßdruck und/oder Einwirkung von Ultraschall;
f) Festklemmen des Bonddrahtes (11) mittels einer diesem zugeordnetem Drahtklemme (13);
g) Hochfahren der Bond-Kapillare (10) samt Drahtklemme (13), wodurch der Bonddraht (11) an der zweiten Bondstelle (16) abgerissen wird;
h) Relativbewegung der Bond-Kapillare (10) gegenüber dem nach wie vor festgeklemmten Bonddraht (11) nach oben durch eine Betätigungseinrichtung, unter Freilegung eines freien Bonddrahtendes bzw-tails (31) mit vorbestimmter "tail-length", wobei diese Relativbewegung alternativ auch vor dem Hochfahren der Bond-Kapillare (10) samt Drahtklemme (13) durchführbar ist;
i) Abflammen des tails (31) unter Ausbildung eines neuen balls (12);
j) Zurückbewegung der Bond-Kapillare (10) relativ zum Bonddraht (11) in die Relativstellung gemäß Arbeitsschritt (g) nach vorheriger Freigabe des Bonddrahtes (11) durch Öffnen der Drahtklemme (13);
k) Absenken der Bond-Kapillare (10) unter Mitnahme des balls (12) samt Bonddraht (11) zu einer neuen ersten Bondstelle (17) und Aufschweißen des balls (12) an dieser entsprechend Arbeitsschritt (b).

2. Verfahren nach Anspruch 1,
**dadurch gekennzeichnet, daß**
bei Freigabe des Bonddrahtes (11) gemäß Arbeitsschritt (j) der Bonddraht (11) durch Einwirkung von Unterdruck, Reibrollen oder dgl. Mittel in Rückzugsstellung gehalten wird, derart, daß der ball (12) an der Unterseite der Bond-Kapillare (10) in Anlage gehalten wird.

3. Vorrichtung zur Durchführung des Verfahrens nach Anspruch 1 oder 2, mit einer Bond-Kapillare (10), durch die hindurch ein Bonddraht 11 geführt und mittels derer der Bonddraht (11) auf eine Bondstelle (16) bzw. (17) aufschweißbar ist, und einer am Bonddraht (11) angreifenden Drahtklemme (13), mittels derer der Bonddraht (11) bei Bedarf festklemmbar ist,
**dadurch gekennzeichnet , daß**
die Bond-Kapillare (10) in hochgefahrener Stellung und bei festgeklemmtem Bonddraht (11) durch eine Betätigungseinrichtung (21, 22) relativ zum Bonddraht (11) hoch bewegbar ist unter Herstellung des eine vorbestimmte "tail-length" definierenden tails (31), dessen freiem Ende eine Abflammeinrichtung, insbesondere Abflammlanze (18) zustellbar ist, unter Herstellung des balls (12) an diesem.

4. Vorrichtung nach Anspruch 3,
**dadurch gekennzeichnet, daß**
die Betätigungseinrichtung für die Bond-Kapillare (10) einen Schwenkarm, insbesondere einen schwenkbar gelagerten Ultraschall-transducer (19) umfaßt, an dessen einem Ende die Bond-Kapillare (10) angeordnet ist und an dessen anderem Ende ein Bondgewicht, insbesondere in Form einer Torsions-, Zug- (21) oder Druckfeder angreift, entgegen dessen bzw. deren Wirkung ein Verstellorgan (22), insbesondere in Form eines Linearmotors oder Piezo-Antriebes wirksam ist.

5. Vorrichtung nach Anspruch 4,
**dadurch gekennzeichnet, daß**
das Verstellorgan (22) programmierbar ist zum Zweck der Einstellung einer gewünschten "tail-length".

## Claims

1. A method for "ball bonding", more particularly a gold wire bonding method, comprising the following working steps:
a) positioning and lowering a bond capillary (10) with a flame-scarfed bond wire ball (ball 12) at the lower free end of a bond wire (11) from a raised starting position onto a first bonding site (17);
b) welding the ball (12) with the addition of heat, defined surface pressure and/or the action of ultrasound;
c) raising the bond capillary (10);
d) forming a loop (25) of the bond wire;
e) welding the bond wire (11) to a second bonding site (16) with the addition of heat, defined surface pressure and/or the action of ultrasound;
f) clamping the bond wire (11) by means of a wire clamp (13) associated therewith;
g) raising the bond capillary (10) together with the wire clamp (13), causing the bond wire (11) to be broken at the second bonding site (16);
h) relatively moving the bond capillary (10) in relation to the still clamped bond wire (11) upwardly by means of an operating device, thereby exposing a free bond wire end or tail (31) with a predetermined "tail length", wherein this relative movement may alternatively also be implemented before raising the bond capillary (10) together with the wire clamp (13);
i) flame-scarfing the tail (31), forming a new ball (12);
j) moving the bond capillary (10) in relation to the bond wire (11) back into the relative position according to working step (g), after previously releasing the bond wire (11) by opening the wire clamp (13);
k) lowering the bond capillary (10), taking with it the ball (12) together with the bond wire (11), to a new first bonding site (17) and welding the ball (12) to the said bonding site according to working step (b).

2. A method according to Claim 1,
**characterised in that**
when the bond wire (11) is released according to working step (j), the bond wire (11) is held in the retracted position by the action of underpressure, friction rollers or such means, so that the ball (12) is held on the underside of the bond capillary (10) in contact therewith.

3. A device for implementing the method according to Claim 1 or 2, comprising a bond capillary (10), through which a bond wire 11 is passed and by means of which the bond wire (11) is weldable to a bonding site (16) or (17), and a wire clamp (13), acting on the bond wire (11), by means of which the bond wire (11) may be clamped as required,
**characterised in that**
the bond capillary (10) in the raised position and with the bond wire (11) clamped is movable upwardly relative to the bond wire (11) by means of an operating device (21, 22), producing the tail (31) defining a predetermined "tail length", to the free end of which a flame-scarfing device, more particularly a flame-scarfing lance (18), may be advanced, producing the ball (12) on the said free end.

4. A device according to Claim 3,
**characterised in that** the operating device for the bond capillary (10) comprises a pivot arm, more particularly a pivotably mounted ultrasonic transducer (19), the bond capillary (10) being arranged at one end thereof, and a bond weight, more particularly in the form of a torsion spring, tension spring (21) or pressure spring, acting on the other end thereof, an adjusting element (22), more particularly in the form of a linear motor or a piezoelectric drive, being effective against the effect of the said bond weight or spring.

5. A device according to Claim 4,
**characterised in that** the adjusting element (22) is programmable for the purpose of setting a desired "tail length".

## Revendications

1. Procédé de soudure par écrasement de boule, en particulier procédé de soudure par écrasement de fil d'or qui comprend les étapes suivantes :
a) positionnement et descente d'un capillaire de connexion (10) avec une boule de fil de connexion flammé (boule 12) à l'extrémité inférieure libre d'un fil de connexion (11) depuis une position de départ surélevée, sur un premier point de connexion (17) ;
b) soudage de la boule (12) par apport de chaleur, pression mécanique définie et/ou application d'ultrasons ;
c) relevage du capillaire de connexion (10) ;
d) formation d'une boucle de fil de connexion (25) ;
e) soudage du fil de connexion (11) en un deuxième point de connexion (16) par apport de chaleur, pression mécanique définie et/ou application d'ultrasons ;
f) immobilisation du fil de connexion (11) au moyen d'une pince à fil (13) associée à celui-ci ;
g) remontée du capillaire de connexion (10) avec la pince à fil (13), le fil de connexion (11) étant ainsi déchiré au niveau du deuxième point de connexion (16) ;
h) déplacement relatif vers le haut du capillaire de connexion (10) par rapport au fil de connexion (11) encore immobilisé par un dispositif d'actionnement en dégageant une extrémité libre du fil de connexion (queue 31), ce mouvement relatif pouvant également se faire en variante avant la remontée du capillaire de connexion (10) avec la pince à fil (13) ;
i) traitement à la flamme de la queue (31) en formant une nouvelle boule (12) ;
j) mouvement de retour du capillaire de connexion (10) par rapport au fil de connexion (11) jusqu'à la position relative de l'étape (g) après libération préalable du fil de connexion (11) ;
k) descente du capillaire de connexion (10) en entraînant la boule (12) et le fil de connexion (11) jusqu'à un autre point de connexion (17) et soudure de la boule (12) en ce point comme à l'étape (b).

2. Procédé selon la revendication 1, **caractérisé en ce que** par dégagement du fil de connexion (11) à l'étape (j), le fil de connexion (11) est tenu dans la position de retrait par application d'une dépression, de rouleaux à friction ou de moyens analogues, de telle manière que la boule (12) est tenue en appui contre la face inférieure du capillaire de connexion (10).

3. Dispositif pour appliquer le procédé selon la revendication 1 ou 2, avec un capillaire de connexion (10) à travers lequel passe un fil de connexion (11) et au moyen duquel le fil de connexion (11) peut être soudé sur un point de connexion (16, resp. 17), et avec une pince à fil (13) se mettant en prise sur le fil de connexion (11), au moyen de laquelle le fil de connexion (11) peut être immobilisé en cas de besoin, **caractérisé en ce que** dans la position remontée avec le fil de connexion (11) immobilisé, le capillaire de connexion (10) peut être pivoté vers le haut par rapport au fil de connexion (11) par un dispositif d'actionnement (21, 22), en créant de la « queue » (31) définissant une « longueur de queue » prédéfinie, à l'extrémité libre de laquelle on peut approcher un dispositif de traitement à la flamme, en particulier une lance à flamme (18), en produisant la boule (12) sur celle-ci.

4. Dispositif selon la revendication 3, **caractérisé en ce que** le dispositif d'actionnement du capillaire de connexion (10) comprend un bras pivotant, en particulier un transducteur à ultrasons (19) monté pivotant, à une extrémité duquel est placé le capillaire de connexion (10) et à l'autre extrémité duquel se met en prise un poids de connexion, en particulier de la forme d'un ressort de torsion, de traction (21) ou de compression, contre l'action duquel agit un organe de déplacement (22) de la forme d'un moteur linéaire ou d'un entraînement piézoélectrique.

5. Dispositif selon la revendication 4, **caractérisé en ce que** l'organe de déplacement (22) est programmable afin d'ajuster une « longueur de queue » souhaitée.
